(19) Europäisches Patentamt
European Patent Office
Office européen des brevets

(11) EP 4 266 389 A1

(12) EUROPEAN PATENT APPLICATION

(43) Date of publication:
25.10.2023 Bulletin 2023/43

(21) Application number: 22168803.9

(22) Date of filing: 19.04.2022

(51) International Patent Classification (IPC):
H01L 43/06 (2006.01)          H01L 43/14 (2006.01)

(52) Cooperative Patent Classification (CPC):
H10N 50/01; H10N 50/10; H10N 50/20; H10N 50/85

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Max-Planck-Gesellschaft zur
Förderung der
Wissenschaften e.V.
80539 München (DE)

(72) Inventors:
• PARKIN, S.P., Stuart
06118 Halle (DE)
• WANG, Peng
06122 Halle (DE)

(74) Representative: Schweitzer, Klaus et al
Plate Schweitzer Zounek
Patentanwälte
Rheingaustrasse 196
65203 Wiesbaden (DE)

(54) GIANT SPIN HALL EFFECT AND SPIN-ORBIT TORQUES IN 5D TRANSITION METAL-ALUMINUM ALLOYS FROM EXTRINSIC SCATTERING

(57) The present invention relates to a Giant spin Hall effect material consisting of $M_xAl_{100\backslash-x}$, wherein M = 5d metal (Lu, Hf, Ta, W, Re, Os, Ir, Pt [=$5d^1$-$5d^9$]), and x= 15-40. Furthermore, the present invention concerns a method of making such Giant spin Hall effect material and a racetrack memory comprising the Giant spin Hall effect material.

## Figure 2

EP 4 266 389 A1

## Description

The generation of spin currents from charge currents via the spin Hall effect is both of fundamental and technological interest. Here we show some of the largest spin Hall effects yet observed via extrinsic scattering in a large class of binary compounds formed from a 5d element and aluminum with a giant spin Hall angle of ~ 1 in the compound $Os_{22}Al_{78}$. We find a critical composition of the 5d element where there is a structural phase boundary between poorly and highly textured crystalline material, where the spin Hall angle takes a maximum value. Furthermore, we find a systematic increase in the spin Hall conductivity and the spin Hall angle at this critical composition as the atomic number of the 5d element is systematically increased. This clearly shows that the spin Hall effect and spin Hall conductivity are derived from extrinsic scattering mechanisms related to the potential mismatch between the 5d element and Al. These studies show the importance of extrinsic mechanisms derived from potential mismatch as a route to obtaining large spin Hall angles with high technological impact. Indeed, we demonstrate that a state-of-the-art racetrack device has a several-fold increased current induced domain wall efficiency using these materials as compared to prior-art materials.

## Introduction

Spintronics is driven by the generation of spin currents and especially their use as spin torques in manipulating magnetization.[1-5] This is the principal mechanism for writing magnetic memory bits in magnetic random-access memories (MRAMs) [6] and in moving magnetic bits, namely domain walls (DW) in magnetic racetrack memories.[7,8] Spin currents can be generated from charge currents via the spin Hall effect (SHE). There has been much interest in certain classes of high-quality, crystalline compounds that could give rise to large spin Hall effects (SHEs) that originate from the intrinsic electronic band structures of such materials[9,10]: such materials include topological insulators,[11-13] and Dirac and Weyl semimetals.[14-16]

Current induced motion of domain walls (DW) in synthetic antiferromagnetic (SAF) racetrack layers has been shown to display high current induced domain wall velocities.[31] Yet, the domain wall velocity still needs to be improved, ideally at simultaneously reduced threshold current density above which the DW starts to move.

Here we show very large SHEs arising rather from extrinsic scattering in highly resistive alloys formed from a 5d element and aluminum at room temperature that are highly useful for practical applications.

The spin-orbit interaction (SOI) plays a central role in the SHE such that, typically, the larger the atomic number Z, the larger is the SHE. Furthermore, the bigger the contrast between Z of the constituent elements in a compound or alloy, the larger will be the extrinsic scattering and, consequently, the SHE.[17,18] In this regard, alloying light metals such as aluminum with a 5d transition metal has the potential to generate a large extrinsic SHE.[19] Here we show that $M_xAl_{100-x}$ (M=Ta, W, Re, Os, Ir, and Pt; x=15-40) alloys exhibit dramatic changes in not only the resistivity $\rho$ but also the spin Hall angle (SHA) $\theta_{SH}$ and spin Hall conductivity (SHC) $\sigma_{SH}$ as a function of their composition, x. We find that there is, in many cases, a transition from a highly disordered, near amorphous phase, to a highly crystalline phase at a critical composition. Furthermore, we find that the resistivity and spin Hall angle exhibit the largest values near the amorphous-crystalline boundary in which extrinsic scattering is maximized. To support this conjecture, we find that the magnitude of the maximum resistivity and the corresponding SHA vary systematically with Z. This shows that the filling of the 5d plays a critical role, such that the resistivity and SHA are related to the number of unpaired electrons in the 5d shell of M, so that $\rho$ exhibits a maximum value for M=Re or Os (number of unpaired d electrons due to Hund's rule = 5, 6, respectively). We find that the resistivity is approximately linearly proportional to the spin Hall angle, so that the power consumption

$$\left(\sim \rho/\theta_{SH}^2\right)$$ that varies inversely with $\theta_{SH}$ is minimized for maximum SHA.[20] Hence, we find that $M_xAl_{100-x}$ are excellent sources of spin-orbit torque sources with smaller power consumptions, compared to established spin Hall metallic elements. On the other hand, we find that when the 5d shell is fully filled, i.e. M=Au, no significant changes in $\rho$ and $\theta_{SH}$ as a function of x are found, thereby confirming that the unpaired orbitals in 5d shell plays a key role in the formation of scattering potentials for $\rho$ and the extrinsic SHE.

## Results and Discussion

### Crystal structure and resistivity of $M_xAl_{100-x}$ alloys

The $M_xAl_{100-x}$ films used in this study were prepared using dc magnetron co-sputtering from a 5d metal M target and an Al sputter target to deposit $M_xAl_{100-x}$ films on top of a [001]-oriented MgO substrate in an ultrahigh vacuum chamber. The composition was varied for x varying from ~10 to ~90 atomic % by varying the power applied to each of the targets. Typical deposition rates were 0.5-2 Å/s and the films were deposited at room temperature. On top of these films were grown magnetic layers to form magnetic racetracks or to form structures suitable for spin-torque ferromagnetic resonance (ST-FMR) studies. The structures were protected from oxidation by a 4 nm thick MgO layer capping layer (see Methods for details). The sheet resistances $R_S$ of the as-grown films are measured by a four-point in-line probe method, from which $\rho$ is obtained from the relationship $\rho = R_S t$, where t is the film thickness. The crystal structures of the films were investigated by x-ray diffraction (XRD) and cross-section transmission electron microscopy (XTEM).

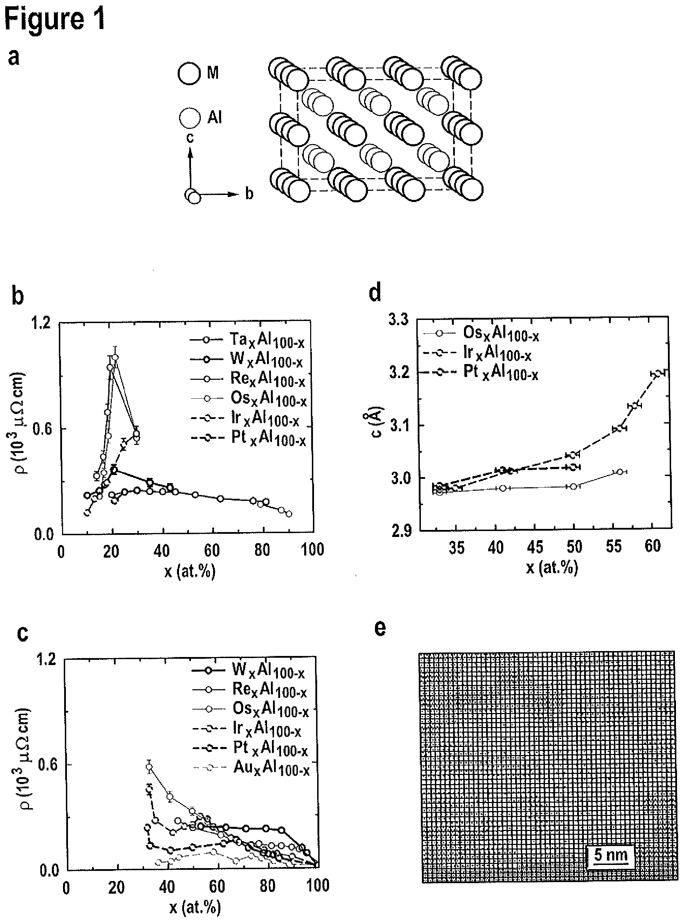

The XRD experiments were carried out with a four-circle diffractometer using Cu-K-$\alpha$1 radiation and employing a two-dimensional pixel detector. The data shown in Figure S1 were collected in the symmetric $\theta$-$2\theta$ scan mode corresponding to longitudinal scans along the [001] direction in reciprocal space. The structure of all the alloys, with the exception of Ta-Al, was found to vary systematically with x, from a poorly crystalline, nearly amorphous structure for small x to a highly textured, crystalline structure for x larger than a critical value, $x_{crit}$ ~20-40 atom %, that depends on M. As M is varied systematically along the 5d period we find a systematic trend to form a well-ordered crystalline phase with increasing number of 5d electrons. For the early elements, Ta and Re, only poorly ordered phases are observed almost independent of x (see Figure S1a and c), while for W we find only the (002) reflection of the bulk-like, completely chemically, disordered phase with space group (SGR) symmetry Im$\bar{3}$m in the region between x=53 and 93 atom %. By contrast, the late d-transition elements (Os, Ir, Pt and Au) form increasingly well-ordered structures of the CsCl type (SGR symmetry Pm$\bar{3}$m, often labelled $L1_0$), as shown in Figure 1a. For instance, a detailed analysis of the $Ir_xAl_{100-x}$ alloys with intermediate values of x indicates almost perfect ordering of the elements on the distinct lattice sites (000) and (½ ½ ½), where only about 10-15 atom % of Ir (Al) are exchanged with the Al (Ir) sites (for more details see SI).

In all cases where a crystalline CsCl-type structure is formed at intermediate values of x, a resistivity maximum is observed at the onset of the long-range order, which is identified at x lying in the range of about x= 20-40 atom %, depending on M (see Figure 1b, c). This concentration likely corresponds to a "percolation limit" where the metal number density exceeds a critical value where the average $M$-$M$ distance and interaction becomes large enough to establish a long-range ordered structure.[21,22] This coincides with the resistivity maximum as the crystalline domains are still small and the number of grain boundaries is large. The maximum value of $\rho$~1100 $\mu\Omega$ cm is observed for $Os_{22}Al_{78}$. The peak values of the resistivity are considerably higher than the end members in each $M$-Al case (~ 3 $\mu\Omega$ cm for Al and Au and 5 to 20 $\mu\Omega$ cm for the other M).

Beyond this critical concentration the resistivity decreases as the size of the coherently scattering domains and the degree of chemical ordering increases. The latter is directly evidenced by the narrowing of the x-ray reflections (see e.g. Figure S1e for x = 50 atom % and Figure S1g for x = 41 atom %). Structural ordering can be estimated by the ratio between the intensities of the (001) and the (002) reflections which has a maximum (i.e. maximum ordering within the CsCl-type structure) for x (atom %) in the range (33 < $x$ < 58) for $Ir_xAl_{100-x}$ as well as for $Pt_xAl_{100-x}$ in the range 32< $x$ <50. Finally in the high-x limit we observe for the $Ir_xAl_{100-x}$ another phase transition to a Fm$\bar{3}$m symmetry Ir metal phase (see Figure S1f), in which the Al atoms can be viewed as diluted within the Ir matrix.

The c lattice parameter systematically increases with increasing x within the crystalline phase region, as shown in Figure 1d. For example, for $Ir_xAl_{100-x}$, c increases by ~ 10% as x is increased from 33 to 61 atom %, consistent with an enhanced tetragonality. For x= 50 atom % cross-sectional transmission electron microscopy shows a highly ordered crystalline phase consistent with the $L1_0$ structure, as shown for $Ir_{50}Al_{50}$ in Figure 1e.

**Evaluation of spin Hall angle**

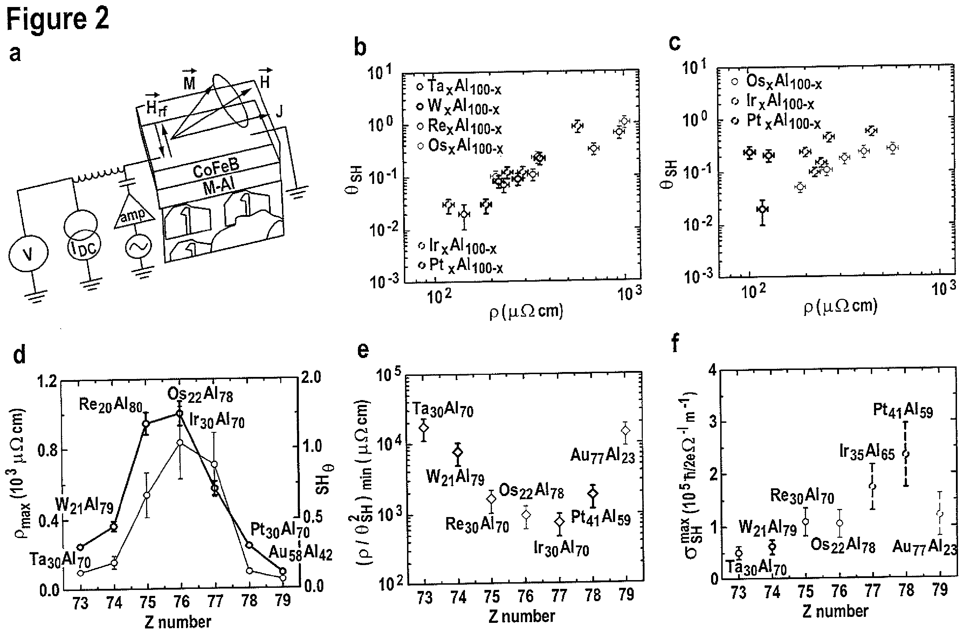

The charge-to-spin conversion efficiency, i.e. the spin Hall angle $\theta_{SH}$ of the $M_xAl_{100-x}$ materials are measured in patterned device structures formed from $M_xAl_{100-x}$ (43 A) | $Co_{20}Fe_{60}B_{20}$ (CFB) (60 Å) using a ferromagnetic layer of CFB and a spin-torque ferromagnetic resonance (ST-FMR) technique (Figure 2a) at ambient temperature by analyzing FMR line widths as a function of DC bias current[23] (see SI for details). Note that the measured $\theta_{SH}$ corresponds to an effective $\theta_{SH}$ that includes the interface transparency[24] between $M$-Al and the CFB ferromagnetic layer that will result in a reduction in the spin current that can cross this interface (and, therefore, the extracted SHA) (see Figure S3 - S9). A very important finding is that, as shown in Figure 2b, $\theta_{SH}$ increases systematically with the resistivity in the poorly crystalline phase of the $M_xAl_{100-x}$ films. The maximum value of $\theta_{SH}$~1.04 is found in Os-Al at the composition that displays the largest value of $\rho$. As for the highly textured $L1_0$ phase in both $Os_xAl_{100-x}$ and $Ir_xAl_{100-x}$, $\theta_{SH}$ also increases with their resistivity, just as in the amorphous phase, while $\theta_{SH}$ for $Pt_xAl_{100-x}$ decreases slightly as $\rho$ increases, as shown in Figure 2c. The values of $\theta_{SH}$ are very large and considerably larger than those that have been reported for the pure elements Pt[23], Ta[25] or W[26], and also oxidized W that displays perhaps the largest value of $\theta_{SH}$ yet reported (~-0.5).[27]

The values of the effective $\theta_{SH}$ found for the member of each $M_xAl_{100-x}$ series of compounds with the maximum resistivity are plotted in Figure 2d versus the atomic number Z. For both $M$ = Os and Ir, values of $\theta_{SH}$ significantly close or larger than 1 are found. Interestingly, $\rho$ displays a similar dependence on Z as does $\theta_{SH}$. These data clearly show that the filling of the 5d-shell plays a key role in the electrical conductivity and charge-to-spin conversion. Note that the power consumption in spin torque processes has been shown to vary as

$$\rho/\theta_{SH}^2$$ .[20] This quantity is plotted versus Z in Figure 2e, showing that the power consumption is minimized near the atomic number at which $\rho$ and $\theta_{SH}$ are maximized. Finally, the spin Hall conductivity $\sigma_{SH} = \theta_{SH} \times$

$\sigma_{xx}$, which is plotted in Figure 2f versus Z, increases monotonically with Z reaching a maximum and very high value of 2.34 ± 0.61 ($10^5$ $\hbar$/2e $\Omega^{-1}$ m$^{-1}$) in Pt$_{41}$AL$_{59}$ (Figure 2f), which is comparable with the previously reported value 2.0 ($10^5$ $\hbar$/2e $\Omega^{-1}$ m$^{-1}$) from Pt$_{80}$AL$_{20}$.[28]

## Current induced domain wall motion in IrAl - SAFs

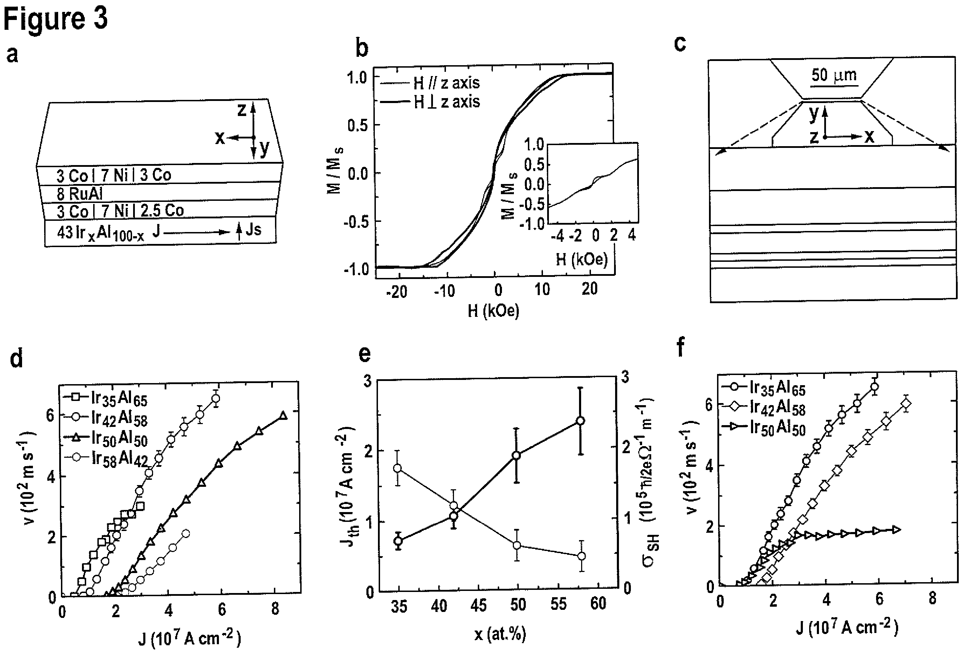

As mentioned earlier, the SHE finds a very important application in the manipulation of magnetization via spin torques derived from spin currents.[29,30] We have applied our finding of giant SHEs in $M_x$Al$_{100-x}$ films to the current induced motion of domain walls in synthetic antiferromagnetic (SAF) racetrack layers, that have been shown to display the highest current induced domain wall velocities.[31] We consider the case of several Ir-Al alloys as the source of the spin current and we form SAF racetracks from Co/Ni/Co trilayer structures grown on top of the $L1_0$-ordered IrAl alloy layer. Interestingly, we find that the Co and Ni layers grow oriented [001] with excellent lattice matching (see SI Figure S14). This is distinct from typical cases in which Co and Ni layers are oriented along [111] when grown on Pt or Ir layers. Furthermore, we find that the Ir-Al | Co | Ni | Co stacks display excellent perpendicular magnetic anisotropy and a large anomalous Hall resistance ($R_H \sim 4\ \Omega$) (see SI Figure S14). Finally, note that we use RuAl as an antiferromagnetic coupling spacer layer instead of Ru since RuAl also forms an $L1_0$-structure on [001]-oriented MgO substrates (see SI Figure S15). The complete film stack of Ir$_x$Al$_{100-x}$ | 3 Co | 7 Ni | 2.5 Co | 8 RuAl | 3 Co | 7 Ni | 3 Co (thickness in Å) shows an [001] orientation throughout the whole stack (see SI Figure S16a). The hysteresis loops of these stacks exhibit out-of-plane magnetized spin-flop transitions, thereby showing that the RuAl spacer layer induces a strong antiferromagnetic exchange coupling between the two Co/Ni/Co ferromagnetic layers (Figure 3b). The ratio of the remanent ($M_R$) to saturation magnetization ($M_S$) is measured to be -0.08, close to zero for an ideal

$$\frac{M_R}{M_S}$$

SAF structure. The ratio reveals a strong dependence on the Ir$_x$Al$_{100-x}$ composition (see SI Figure S16) that we suppose is related to a proximity induced moment in the Ir-Al layer.

To investigate the current-induced domain wall motion, $\mu$m-wide wires with different lengths and widths are fabricated by photolithography and Ar ion milling (an optical image of a typical device is shown in Figure 3c). Kerr microscopy is used to monitor the position of individual domain walls after the application of a succession of 5 ns-long current pulses (see Methods for details). The dependence of the DW velocity, v, on the current density, J, is plotted in Figure 3d for Ir$_x$Al$_{100-x}$ where x is varied from 35 to 58 atom %. Very large DW velocities are found due to a large exchange coupling torque:[32] the largest DW velocity is measured to be ~650 m s$^{-1}$ at $J\sim 6 \times 10^7$ A cm$^{-2}$ for Ir$_{42}$Al$_{58}$. We note that this corresponds to an efficiency that is 3 to 5 times greater than that reported in conventional [111]-textured SAFs based on Co, Ni and Ru layers grown on Pt underlayers. Moreover, the threshold current density, $J_{th}$, above which the DW starts to move is measured to be ~ $5 \times 10^6$ A cm$^{-2}$ for Ir$_{35}$Al$_{65}$ which is considerably lower than previously reported in Ru based SAF structures prepared on Pt layers.[31] The dependence of $J_{th}$ and $\sigma_{SH}$ on Ir content in Ir$_x$Al$_{100-x}$ shows that $J_{th}$ decreases with increasing $\sigma_{SH}$ consistent with an increasing spin-orbit torque (Figure 3e).

The SOT is known to be very sensitive to the detailed structure of the interface between the SOT layer and the magnetic layer.[33] For example, as shown in Figure 3f, 2 Å thick Ir or Al layers inserted at this interface significantly changes the dependence of v on the current density. The insertion of the Al dusting layer results in a lower terminal value of v~200 m/s while $J_c$ does not change. On the other hand, the insertion of the Ir dusting layer shifts the v - J curve to higher J thus increasing $J_c$. These observations can be accounted for by: (i) a decrease in the DMI by the insertion of an Al dusting layer as compared with the insertion of an Ir dusting layer [34]; (ii) a decrease in the exchange coupling torque [31] due to the increased ratio of $M_R$/ Ms for the Al insertion layers as compared with the Ir insertion layers, as shown in Figure S18; (iii) an increase in spin memory loss ($\delta = t / l_{sf}$, t is the thickness of the dusting layer and $l_{sf}$ is the spin diffusion length) arising from the strong spin-orbit interaction of Ir that degrades the strength of the spin-orbit torque as compared with the weaker spin-orbit interaction from Al which displays a very long spin diffusion length [35,36,37]. The degradation of the spin-orbit torque leads to an increase of $J_c$ for the Ir insertion layers.

## Spin-orbit torque switching of IrAl-SAFs

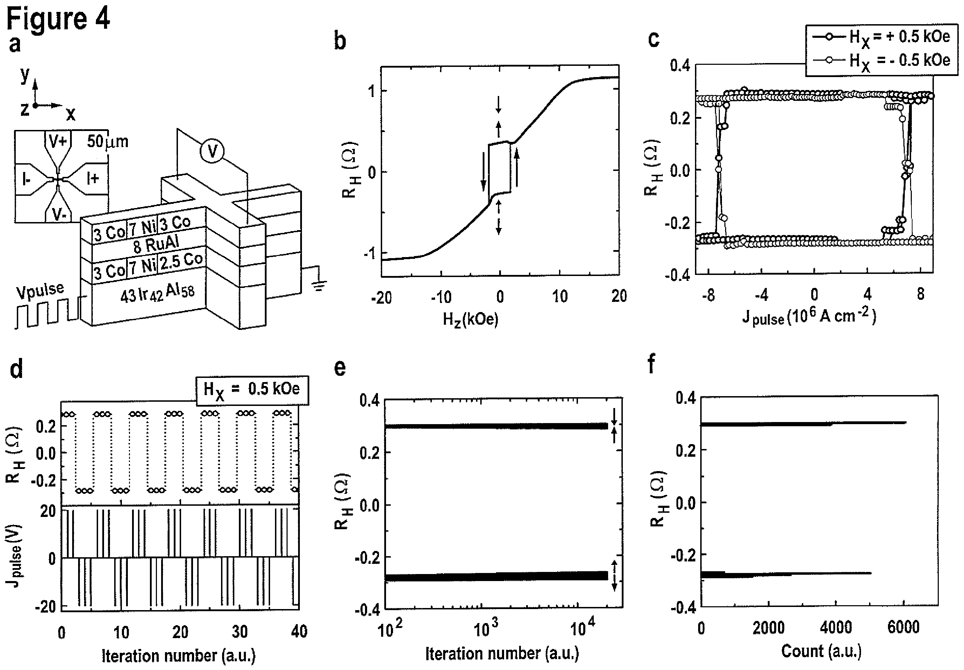

To further evaluate the SHE from Ir-Al, we carry out SOT-switching experiments using standard Hall bars[25] formed from a synthetic antiferromagnetic (SAF) structure (see the inset of Figure 4a and SI for the details). The Hall resistance, that is swept along the magnetic easy-axis (out-of-plane), is plotted in Figure 4b, showing a well-defined spin-flop transition. Current pulses are applied along the Hall bar as an external magnetic field applied along the current direction is switched between ~ ±500 Oe (Figure 4c). The change in Hall resistance equals that for the magnetic field induced switching (Figure 4b) for the field range from ~ + 3 kOe to ~ - 3 kOe), thereby showing a complete switching of the SAF layer at $J \sim \pm 7$ MA/cm$^2$, which is a smaller critical current density than needed for realistic applications.[3] The flipping of the Hall resistance upon reversal of the in-plane field direction confirms the SOT switching of the magnetic layers.[38] To investigate the reproducibility and reliability of the current induced switching, the switching experiments were repeated more than 10,000 times without any failure, as shown in Figure 4d-f (see Methods and SI for further details).

## Conclusion

Alloys of 5d elements with light elements are shown to give rise to very large spin Hall angles that exceed those of the best known non-topological materials to date. The largest values of $\rho$ and $\theta_{SH}$ are observed to be ~1,000 $\mu\Omega$ cm and 1.04, respectively, in the alloy $Os_{22}Al_{78}$, while the largest value of $\sigma_{SH}$ is found to be 2.34 ($10^5$ $\hbar/2e$ $\Omega^{-1}m^{-1}$) in $Pt_{41}Al_{59}$. Moreover, these materials can be prepared by straightforward sputter deposition techniques, rather than molecular beam epitaxy methods, and, furthermore, act as a template for the growth of highly crystalline textured magnetic layers and heterostructures that are the basis of several emerging magnetic nonvolatile memory and storage technologies. We demonstrate that using Ir-Al as the source of spin current, highly efficient chiral domain wall motion is found in synthetic antiferromagnetic racetracks with a very low threshold current density. An important finding is that the largest spin Hall angles are found at compositions that lie close to a phase boundary where the structure loses its crystalline texture, and, that the magnitude of the spin Hall angle scales with the resistivity of the 5d-alloy, clearly demonstrating the extrinsic origin of the spin Hall effect. Finally, the power consumption for spin orbit torque switching is minimized for the most resistive alloys. Our findings show that the giant SHE and spin-orbit torques in $M_xAl_{100-x}$ alloys can provide an excellent platform for potential applications in diverse memory and logic devices with highly efficient interconversion of charge-to-spin currents and low power consumption.

## Brief Description of the Figures

**Figure 1.** Crystal structure and electronic properties. a) Schematic diagram of the chemically ordered CsCl-type $M$-Al structure ($M$ = Os, Ir, and Pt). b, c) Sheet resistivity of $M_xAl_{100-x}$ with a poorly crystalline phase (b), and a highly textured crystalline phase (c) as a function of x, respectively. d) Out-of-plane lattice parameter c as a function of x for $Os_xAl_{100-x}$, $Ir_xAl_{100-x}$ and $Pt_xAl_{100-x}$ with the $L1_0$ structure. e) HADDF-STEM image of a 300 Å thick $Ir_{50}Al_{50}$ thin film.

**Figure 2.** ST-FMR measurements of $M_xAl_{100-x}$ | $Co_{20}Fe_{60}B_{20}$ devices. a) Illustration of the ST-FMR experimental setup. b) Effective $\theta_{SH}$ as a function of resistivity for several $M_xAl_{100-x}$ compounds which display poor crystallinity. c) Effective $\theta_{SH}$ as a function of resistivity for $M_xAl_{100-x}$ with an $L1_0$ crystalline

structure. d) Maximum resistivity and effective $\theta_{SH}$ at the same x for $M_xAl_{100-x}$ as a function of atomic number Z. e) The minimum ratio of $\rho/\theta_{SH}^2$ of $M_xAl_{100-x}$ as a function of Z. f) Maximum spin Hall conductivity $\sigma_{SH}$ in $M_xAl_{100-x}$ | $Co_{20}Fe_{60}B_{20}$ samples as a function of Z.

**Figure 3.** Current induced domain wall motion in $Ir_xAl_{100-x}$ synthetic antiferromagnetic (SAF) racetracks. a) Schematic of SAF multilayer with an $Ir_xAl_{100-x}$ underlayer. b) Out-of-plane (red) and in-plane (blue) magnetic hysteresis loops for 43 Å $Ir_{50}Al_{50}$ | SAFs with the out-of-plane M-H loop shown in the inset. c) Optical micrograph of the racetrack device and Kerr microscopy differential images showing the propagation of a single domain wall along the track, in response to a sequence of 5-ns-long current pulses (J ~ 1.2 × $10^8$ A cm$^{-2}$). d) DW velocity v versus pulse current density J in nanowires formed from 43 Å $Ir_xAl_{100-x}$ | SAFs. e) Critical threshold current density ($J_{th}$) to drive the domain walls in $Ir_xAl_{100-x}$ | SAF structures, and spin Hall conductivity of $Ir_xAl_{100-x}$ as a function of x. f) DW velocity versus pulse current density in nanowires formed from 43 Å $Ir_{42}Al_{58}$ | no dusting layer and dusting layer of 2 M (M =Ir and Al) | SAFs.

**Figure 4.** Spin-orbit-torque magnetization switching. a) Schematic diagrams of sample stack and Hall bar devices. b) Anomalous Hall resistance ($R_H$) as a function of out-of-plane magnetic field H in 43 Å $Ir_{42}Al_{58}$ | SAF structures measured at 300 K. c) Magnetization switching of 43 Å $Ir_{42}Al_{58}$ | SAF with in-plane field of ±500 Oe at 300 K. d) Deterministic magnetization switching in 43 Å $Ir_{42}Al_{58}$ | SAF devices by a series of ~ ±20 V pulses. e) Anomalous Hall resistance switched by a series of positive and negative voltage pulses as a function of iteration number. f) Deterministic switching of anomalous Hall resistance.

## Experimental section

*Sample Preparation, Characterization and Device Fabrication:* The films were deposited in an AJA 'Flagship Series' sputtering system onto 10x10 mm$^2$ MgO (100) substrates. The base pressure before deposition was less than $10^{-8}$ Torr and the Ar gas pressure during deposition was 3 mTorr. The $M_xAl_{100-x}$ and RuAl films were prepared by co-sputtering from heavy metal and Al targets. The $Co_{20}Fe_{60}B_{20}$ layer was prepared by sputtering from a single target with a composition of $Co_{20}Fe_{60}B_{20}$. Highly resistive 50 Å thick TaN-capping layers were fabricated by introducing 20% $N_2$ into the Ar sputtering gas. The composition of the $M_xAl_{100-x}$ layers was determined by Rutherford backscattering spectrometry (RBS) with an accuracy of ~1- 2 atomic %. High-resolution XRD measurements were performed using a Bruker D8 Discover system with Cu K$\alpha_1$ radiation ($\lambda$ = 1.54 A) at room temperature. Magnetization hysteresis loops were measured using a superconducting quantum interference device vibrating sample magnetometer (SQUID-VSM). Lamella were prepared for XTEM with focused ion beam milling using a Tescan GAIA3 instrument. TEM data were measured in a FEI Titan 80-300 (scanning) TEM equipped with a CEOS CESCOR third-order axial geometric aberration corrector and a Gatan UltraScan 1000 slow-scan CCD camera. The primary electron energy was 300 kV. Device fabrication was carried out using optical lithography and ion beam etching. Subsequently, 3nm thick Ti and 80 nm thick Au electrical contact layers were deposited using a lift-off process. The resistance of the $M_x$Al$_{100-x}$ films was measured using a Veeco FPP5000 four-point probe station. The thickness of the $M_x$Al$_{100-x}$ thin films was measured using a Bruker Dimensional Icon Atomic Force Microscope.

*Spin-Torque Ferromagnetic Resonance:* ST-FMR measurements were performed at room temperature in micro-strip devices of various sizes. A gigahertz frequency probe tip (Picoprobe Model 40A) was used to inject an RF excitation current (Keysight MXG N5183B signal generator) at a power of 20 dBm. The rectified DC voltage across the micro-strip was simultaneously measured using a bias-tee (Tektronix PSPL5545) and a nanovoltmeter (Keithley 2182A). The rectified DC voltage resulting from mixing of the RF current with the varying resistance of the micro-strip due to the anisotropic magnetoresistance of the $Co_{20}Fe_{60}B_{20}$ layer gives rise to the FMR signal. The FMR signal at a particular excitation frequency is measured as the external in-plane magnetic field is swept, at an angle of 45° to the long axis of the micro-strip. The D.C bias current was applied from -2 to 2 mA with an RF-current with a frequency of 9 GHz to extract the half-width of the ferromagnetic resonance peak to obtain the effective spin Hall angle.

*Measurement of DW Velocity:* Kerr optical microscopy in differential mode was used to monitor the position of the DW along the nanowire in response to a series of current pulses. The sensitivity of this technique is sufficient to detect the motion of single DWs in nanowires as narrow as ~ 100 nm. Images are taken after a fixed number of current pulses chosen such that the DW has moved by a significant distance, typically ~ 1-2 µm. The DW velocity is then determined by assuming that the DW moves only during pulses. We use a linear fit of the DW position versus the integrated current pulse length $t_{CP}$, that is, the product of pulse duration and the number of pulses applied. In some cases, the DW may be pinned by a local defect until enough pulses are applied to dislodge it. In these cases, we fit only the portions of the curve in which the DW position depends linearly on $t_{CP}$. The standard deviation of the differential velocity, that is, the point-by-point derivative of the DW position versus $t_{CP}$ curve, is used to determine an error bar. Note that we define the DW velocity to be positive (negative) when the DWs move along the current (against) flow.

*Electronic Transport Measurements:* Electrical transport measurements, including (ST-FMR), Hall measurement, and electrical switching measurement, were performed at room temperature. For conventional Hall measurements, a DC current source (Keithley 6221) and a nanovoltmeter (Keithley 2182a) were used. Electrical switching experiments using ms-long current pulses were made with a multifunctional source meter (Keithley 2635B). More details are given in Supporting Information.

*Statistical Analysis:* 1. Pre-processing of data: $\sigma$ = 1/p, $M$ / $M_s$ ($M_s$ is saturation magnetization, M is magnetization versus magnetic field). 2.

$$SD = \sqrt{\frac{\sum(x-\bar{x})^2}{n-1}}, \quad \bar{x} = \frac{(\sum x)}{n}$$

, 3. Sample size (n) is 5. 4. Two-sided testing with alpha value (0.05) and P value (0.5734). 5. Software used for statistical analysis: Origin 2019.

## References

[1] J. Sinova, S. O. Valenzuela, J. Wunderlich, C. H. Back, T. Jungwirth, Rev. Mod. Phys. 2015, 87, 1213.

[2] A. Manchon, J. Železny, I. M. Miron, T. Jungwirth, J. Sinova, A. Thiaville, K. Garello, P. Gambardella, Rev. Mod. Phys. 2019, 91, 035004.

[3] Q. Shao, P. Li, L. Liu, H. Yang, S. Fukami, A. Razavi, H. Wu, F. Freimuth, Y. Mokrousov, M. D. Stiles, S. Emori, A. Hoffmann, J. Akerman, K. Roy, J.-P. Wang, S.-H. Yang, K. Garellob, W. Zhang, IEEE Trans. Magn. 2021, 1.

[4] S.-H. Yang, Appl. Phys. Lett. 2020, 116, 120502.

[5] S.-H. Yang, R. Naaman, Y. Paltiel, S. S. P. Parkin, Nat. Rev. Phys., 2021, 3, 328.

[6] S. Ikegawa, F. B. Mancoff, J. Janesky, S. Aggarwal, IEEE Trans. Electron Devices, 2020, 67, 1407.

[7] S. Parkin, S.-H. Yang, Memory on the racetrack. Nat. Nanotech., 2015, 10, 195.

[8] S. S. P. Parkin, M. Hayashi, L. Thomas, Science. 2008, 320, 190.

[9] Z. Chi, Y.-C. Lau, X. Xu, T. Ohkubo, K. Hono, M. Hayashi, Sci. Adv. 2020, 6, eaay2324.

[10] M. Dc, R. Grassi, J.-Y. Chen, M. Jamali, D. R. Hickey, D. Zhang, Z. Zhao, H. Li, P. Quarterman, Y. Lv, M. Li, A. Manchon, K. A. Mkhoyan, T. Low, J.-P. Wang, Nat. Mater. 2018, 17, 800.

[11] M. Mogi, K. Yasuda, R. Fujimura, R. Yoshimi, N. Ogawa, A. Tsukazaki, M. Kawamura, K. S. Takahashi, M. Kawasaki, Y. Tokura, Nat. Commun. 2021, 12, 1404.

[12] K. Kondou, R. Yoshimi, A. Tsukazaki, Y. Fukuma, J. Matsuno, K. S. Takahashi, M. Kawasaki, Y.

Tokura, Y. Otani, Nat. Phys. 2016, 12, 1027.

[13] H. Wu, P. Zhang, P. Deng, Q. Lan, Q. Pan, S. A. Razavi, X. Che, L. Huang, B. Dai, K. Wong, X. Han, K. L. Wang, Phys. Rev. Lett. 2019, 123, 207205.

[14] B. Zhao, D. Khokhriakov, Y. Zhang, H. Fu, B. Karpiak, A. Md. Hoque, X. Xu, Y. Jiang, B. Yan, S. P. Dash, Phys. Rev. Research. 2020, 2, 013286.

[15] N. P. Armitage, E. J. Mele, A. Vishwanath, Rev. Mod. Phys. 2018, 90, 015001.

[16] N. Nagaosa, T. Morimoto, Y. Tokura, Nat. Rev. Mater. 2020, 5, 621.

[17] Y. Niimi, Y. Kawanishi, D. H. Wei, C. Deranlot, H. X. Yang, M. Chshiev, T. Valet, A. Fert, Y. Otani, Phys. Rev. Lett. 2012, 109, 156602.

[18] X. Shu, J. Zhou, J. Deng, W. Lin, J. Yu, L. Liu, C. Zhou, P. Yang, J. Chen, Phys. Rev. Mater. 2019, 3, 114410.

[19] Y.-C. Lau, T. Seki, K. Takanashi,. APL Mater. 2021, 9, 081113.

[20] J. Han, A. Richardella, S. A. Siddiqui, J. Finley, N. Samarth, L. Liu, Phys. Rev. Lett. 2017, 119, 077702.

[21] P. Jensen, A.-L. Barabási, H. Larralde, S. Havlin, H. E. Stanley, Chaos, Solitons & Fractals. 1995, 6, 227.

[22] P. Šmilauer, Contemp. Phys. 1991, 32, 89.

[23] L. Liu, T. Moriyama, D. C. Ralph, R. A. Buhrman, Phys. Rev. Lett. 2011, 106, 036601.

[24] W. Zhang, W. Han, X. Jiang, S.-H. Yang, S. S. P. Parkin, Nat. Phys. 2015, 11, 496.

[25] L. Liu, C.-F. Pai, Y. Li, H. W. Tseng, D. C. Ralph, R. A. Buhrman, Science. 2012, 336, 555.

[26] J. Liu, T. Ohkubo, S. Mitani, K. Hono, M. Hayashi, Appl. Phys. Lett. 2015, 107, 232408.

[27] K.-U. Demasius, T. Phung, W. Zhang, B. P. Hughes, S.-H. Yang, A. Kellock, W. Han, A. Pushp, S. S. P. Parkin, Nat. Commun. 2016, 7, 1.

[28] M.-H. Nguyen, M. Zhao, D. C. Ralph, R. A. Buhrman, Appl. Phys. Lett. 2016, 108, 242407.

[29] K.-S. Ryu, L. Thomas, S.-H. Yang, S. Parkin, Nat. Nanotech. 2013, 8, 527.

[30] K.-S. Ryu, S.-H. Yang, L. Thomas, S. S. P. Parkin, Nat. Commun. 2014, 5, 3910.

[31] S.-H. Yang, K.-S. Ryu, S. Parkin, Nat. Nanotech. 2015, 10, 221.

[32] R. Bläsing, T. Ma, S.-H. Yang, C. Garg, F. K. Dejene, A. T. N'Diaye, G. Chen, K. Liu, S. S. P. Parkin, Nat. Commun. 2018, 9, 4984.

[33] Y. Guan, X. Zhou, T. Ma, R. Bläsing, H. Deniz, S.-H. Yang, S. S. P. Parkin, Adv. Mater. 2021, 33, 2007991.

[34] F. Ajejas, V. Křižáková, D.S. Chaves, J. Vogel, P. Perna, R. Guerrero, A. Gudin, J. Camarero, S. Pizzini. Appl. Phys. Lett. 2017, 111, 202402.

[35] K. Gupta, R.J.H. Wesselink, R. Liu, Z. Yuan, P.J. Kelly. Phys. Rev. Lett. 2020, 124, 087702.

[36] T. Fache, J. C. Rojas-Sanchez, L. Badie, S.

Mangin, S. Petit-Watelot Phys. Rev. B, 2020, 102, 064425.

[37] J. Bass, W. P. Pratt, J. Condens. Matter Phys. 2007, 19, 183201.

[38] P. X. Zhang, L. Y. Liao, G. Y. Shi, R. Q. Zhang, H. Q. Wu, Y. Y. Wang, F. Pan, C. Song, Phys. Rev. B. 2018, 97, 214403.

## Claims

1. A Giant spin Hall effect material consisting of $M_xAl_{100-x}$ wherein M = 5d metal (Lu, Hf, Ta, W, Re, Os, Ir, Pt [=$5d^1$-$5d^9$]), and x= 15-40.

2. The Giant spin Hall effect material according to claim 1, wherein x= 18-35.

3. The Giant spin Hall effect material according to claim 1 or 2, wherein $M$=W, Re, Os or Ir.

4. The Giant spin Hall effect material according to claim 1, 2 or 3, wherein M=Re or Os.

5. The Giant spin Hall effect material according to one of claims 1-4, wherein $M_xAl_{100-x}$ is oriented along the [001] axis.

6. A racetrack memory device comprising a Giant spin Hall effect material according to one of claims 1-5.

7. The Racetrack memory device according to claim 6, wherein the racetrack has the layer sequence $M_xAl_{100-x}$ | Co | Ni | Co | RuAl | Co | Ni | Co, wherein M = 5d metal (Lu, Hf, Ta, W, Re, Os, Ir, Pt [=$5d^1$-$5d^9$]), and x= 15-40.

8. The Racetrack memory device according to claim 6 or 7, wherein M= W, Re, Os or Ir

9. The Racetrack memory device according to claim 6, 7 or 8, wherein x= 15-40.

10. The Racetrack memory device according to one of claims 6-9, wherein x= 18-35.

11. A method of manufacturing the Giant spin Hall effect material according to claim 1, comprising depositing films of the $M_xAl_{100-x}$ alloy in a sputtering system by co-sputtering 5d metal and Al targets, wherein M = 5d metal (Lu, Hf, Ta, W, Re, Os, Ir, Pt [=$5d^1$-$5d^9$]), and x= 15-40.

12. Method of manufacturing the racetrack according to claim 6 comprising depositing films of the $M_xAl_{100-x}$ alloy onto MgO (100) substrates, wherein M = 5d metal (Lu, Hf, Ta, W, Re, Os, Ir, Pt [=$5d^1$-$5d^9$]), and x= 15-40.

**13.** Use of the Giant spin Hall effect material according to claim 1 in MRAMS.

# Figure 1

a

b

c

d

e

Figure 2

Figure 3

Figure 4

# EP 4 266 389 A1

Europäisches
Patentamt

European
Patent Office

Office européen
des brevets

# EUROPEAN SEARCH REPORT

Application Number

EP 22 16 8803

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG PENG ET AL: "Giant Spin Hall Effect and Spin-Orbit Torques in 5 d Transition Metal-Aluminum Alloys from Extrinsic Scattering", ADVANCED MATERIALS, [Online] vol. 34, no. 23, 1 April 2022 (2022-04-01), page 2109406, XP055971955, DE ISSN: 0935-9648, DOI: 10.1002/adma.202109406 Internet Retrieved from the Internet: URL:https://onlinelibrary.wiley.com/doi/full-xml/10.1002/adma.202109406> [retrieved on 2022-10-18] * paragraphs [0001], [02.3], [0003] - paragraph [0004] * ----- | 1-13 | INV. H01L43/06 H01L43/14 |
| A | EP 3 916 728 A1 (MAX PLANCK GESELLSCHAFT [DE]) 1 December 2021 (2021-12-01) * paragraph [0035]; claims 1, 8 * ----- | 1-13 | |
| A | WANG KANG ET AL: "Advanced Low Power Spintronic Memories beyond STT-MRAM", GREAT LAKES SYMPOSIUM ON VLSI 2017, ACM, 2 PENN PLAZA, SUITE 701 NEW YORK NY 10121-0701 USA, 10 May 2017 (2017-05-10), pages 299-304, XP058339225, DOI: 10.1145/3060403.3060589 ISBN: 978-1-4503-4972-7 * page 300, paragraph 2 * ----- | 1-13 | TECHNICAL FIELDS SEARCHED (IPC) H01L |

The present search report has been drawn up for all claims

| Place of search | Date of completion of the search | Examiner |
|---|---|---|
| Munich | 18 October 2022 | Angermeier, Detlef |

EPO FORM 1503 03.82 (P04C01)

## ANNEX TO THE EUROPEAN SEARCH REPORT
## ON EUROPEAN PATENT APPLICATION NO.

EP 22 16 8803

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2022

| Patent document cited in search report | | Publication date | Patent family member(s) | | Publication date |
|---|---|---|---|---|---|
| EP 3916728 | A1 | 01-12-2021 | EP 3916728 | A1 | 01-12-2021 |
| | | | WO 2021239690 | A1 | 02-12-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- J. SINOVA ; S. O. VALENZUELA ; J. WUNDERLICH ; C. H. BACK ; T. JUNGWIRTH. *Rev. Mod. Phys.*, 2015, vol. 87, 1213
- A. MANCHON ; J. ŽELEZNÝ ; I. M. MIRON ; T. JUNGWIRTH ; J. SINOVA ; A. THIAVILLE ; K. GARELLO ; P. GAMBARDELLA. *Rev. Mod. Phys*, 2019, vol. 91, 035004
- Q. SHAO ; P. LI ; L. LIU ; H. YANG ; S. FUKAMI ; A. RAZAVI ; H. WU ; F. FREIMUTH ; Y. MOKROUSOV ; M. D. STILES. *IEEE Trans. Magn.*, 2021, vol. 1
- S.-H. YANG. *Appl. Phys. Lett.*, 2020, vol. 116, 120502
- S.-H. YANG ; R. NAAMAN ; Y. PALTIEL ; S. S. P. PARKIN. *Nat. Rev. Phys.*, 2021, vol. 3, 328
- S. IKEGAWA ; F. B. MANCOFF ; J. JANESKY ; S. AGGARWAL. *IEEE Trans. Electron Devices*, 2020, vol. 67, 1407
- S. PARKIN ; S.-H. YANG. Memory on the racetrack. *Nat. Nanotech.*, 2015, vol. 10, 195
- S. S. P. PARKIN ; M. HAYASHI ; L. THOMAS. *Science*, 2008, vol. 320, 190
- Z. CHI ; Y.-C. LAU ; X. XU ; T. OHKUBO ; K. HONO ; M. HAYASHI. *Sci. Adv.*, 2020, vol. 6, eaay2324
- M. DC ; R. GRASSI ; J.-Y. CHEN ; M. JAMALI ; D. R. HICKEY ; D. ZHANG ; Z. ZHAO ; H. LI ; P. QUARTERMAN ; Y. LV. *Nat. Mater.*, 2018, vol. 17, 800
- M. MOGI ; K. YASUDA ; R. FUJIMURA ; R. YOSHIMI ; N. OGAWA ; A. TSUKAZAKI ; M. KAWAMURA ; K. S. TAKAHASHI ; M. KAWASAKI ; Y. TOKURA. *Nat. Commun.*, 2021, vol. 12, 1404
- K. KONDOU ; R. YOSHIMI ; A. TSUKAZAKI ; Y. FUKUMA ; J. MATSUNO ; K. S. TAKAHASHI ; M. KAWASAKI ; Y. TOKURA ; Y. OTANI. *Nat. Phys.*, 2016, vol. 12, 1027
- H. WU ; P. ZHANG ; P. DENG ; Q. LAN ; Q. PAN ; S. A. RAZAVI ; X. CHE ; L. HUANG ; B. DAI ; K. WONG. *Phys. Rev. Lett.*, 2019, vol. 123, 207205
- B. ZHAO ; D. KHOKHRIAKOV ; Y. ZHANG ; H. FU ; B. KARPIAK ; A. MD. HOQUE ; X. XU ; Y. JIANG ; B. YAN ; S. P. DASH. *Phys. Rev. Research.*, 2020, vol. 2, 013286
- N. P. ARMITAGE ; E. J. MELE ; A. VISHWANATH. *Rev. Mod. Phys.*, 2018, vol. 90, 015001
- N. NAGAOSA ; T. MORIMOTO ; Y. TOKURA. *Nat. Rev. Mater.*, 2020, vol. 5, 621
- Y. NIIMI ; Y. KAWANISHI ; D. H. WEI ; C. DERANLOT ; H. X. YANG ; M. CHSHIEV ; T. VALET ; A. FERT ; Y. OTANI. *Phys. Rev. Lett.*, 2012, vol. 109, 156602
- X. SHU ; J. ZHOU ; J. DENG ; W. LIN ; J. YU ; L. LIU ; C. ZHOU ; P. YANG ; J. CHEN. *Phys. Rev. Mater.*, 2019, vol. 3, 114410
- Y.-C. LAU ; T. SEKI ; K. TAKANASHI. *APL Mater.*, 2021, vol. 9, 081113
- J. HAN ; A. RICHARDELLA ; S. A. SIDDIQUI ; J. FINLEY ; N. SAMARTH ; L. LIU. *Phys. Rev. Lett.*, 2017, vol. 119, 077702
- P. JENSEN ; A.-L. BARABÁSI ; H. LARRALDE ; S. HAVLIN ; H. E. STANLEY. *Chaos, Solitons & Fractals.*, 1995, vol. 6, 227
- P. ŠMILAUER. *Contemp. Phys.*, 1991, vol. 32, 89
- L. LIU ; T. MORIYAMA ; D. C. RALPH ; R. A. BUHRMAN. *Phys. Rev. Lett.*, 2011, vol. 106, 036601
- W. ZHANG ; W. HAN ; X. JIANG ; S.-H. YANG ; S. S. P. PARKIN. *Nat. Phys.*, 2015, vol. 11, 496
- L. LIU ; C.-F. PAI ; Y. LI ; H. W. TSENG ; D. C. RALPH ; R. A. BUHRMAN. *Science*, 2012, vol. 336, 555
- J. LIU ; T. OHKUBO ; S. MITANI ; K. HONO ; M. HAYASHI. *Appl. Phys. Lett.*, 2015, vol. 107, 232408
- K.-U. DEMASIUS ; T. PHUNG ; W. ZHANG ; B. P. HUGHES ; S.-H. YANG ; A. KELLOCK ; W. HAN ; A. PUSHP ; S. S. P. PARKIN. *Nat. Commun.*, 2016, vol. 7, 1
- M.-H. NGUYEN ; M. ZHAO ; D. C. RALPH ; R. A. BUHRMAN. *Appl. Phys. Lett.*, 2016, vol. 108, 242407
- K.-S. RYU ; L. THOMAS ; S.-H. YANG ; S. PARKIN. *Nat. Nanotech.*, 2013, vol. 8, 527
- K.-S. RYU ; S.-H. YANG ; L. THOMAS ; S. S. P. PARKIN. *Nat. Commun.*, 2014, vol. 5, 3910
- S.-H. YANG ; K.-S. RYU ; S. PARKIN. *Nat. Nanotech.*, 2015, vol. 10, 221
- R. BLÄSING ; T. MA ; S.-H. YANG ; C. GARG ; F. K. DEJENE ; A. T. N'DIAYE ; G. CHEN ; K. LIU ; S. S. P. PARKIN. *Nat. Commun.*, 2018, vol. 9, 4984
- Y. GUAN ; X. ZHOU ; T. MA ; R. BLÄSING ; H. DENIZ ; S.-H. YANG ; S. S. P. PARKIN. *Adv. Mater.*, 2021, vol. 33, 2007991

- **F. AJEJAS ; V. KŘIŽÁKOVÁ ; D.S. CHAVES ; J. VOGEL ; P. PERNA ; R. GUERRERO ; A. GUDIN ; J. CAMARERO ; S. PIZZINI.** *Appl. Phys. Lett.,* 2017, vol. 111, 202402
- **K. GUPTA ; R.J.H. WESSELINK ; R. LIU ; Z. YUAN ; P.J. KELLY.** *Phys. Rev. Lett,* 2020, vol. 124, 087702
- **T. FACHE ; J. C. ROJAS-SANCHEZ ; L. BADIE ; S. MANGIN ; S. PETIT-WATELOT.** *Phys. Rev. B,* 2020, vol. 102, 064425
- **J. BASS ; W. P. PRATT.** *J. Condens. Matter Phys.,* 2007, vol. 19, 183201
- **P. X. ZHANG ; L. Y. LIAO ; G. Y. SHI ; R. Q. ZHANG ; H. Q. WU ; Y. Y. WANG ; F. PAN ; C. SONG.** *Phys. Rev. B.,* 2018, vol. 97, 214403